# EUROPÄISCHE PATENTSCHRIFT

(11) **EP 3 109 911 B1**
(45) Veröffentlichungstag und Bekanntmachung des Hinweises auf die Patenterteilung: **10.04.2019**
(21) Anmeldenummer: 16167882.6
(22) Anmeldetag: 02.05.2016
(51) Int. Cl.: H01L 41/047, H01L 41/053

(54) **PIEZOAKTORMODUL, VERFAHREN ZUM HERSTELLEN EINES PIEZOAKTORMODULS UND PIEZOINJEKTOR**
PIEZO ACTUATOR MODULE, METHOD FOR PRODUCING A PIEZO ACTUATOR MODULE AND PIEZO INJECTOR
MODULE DE PIEZOACTIONNEUR, PROCEDE DE PRODUCTION D'UN MODULE DE PIEZOACTIONNEUR ET PIEZOINJECTEUR

(30) Priorität: 26.06.2015 DE 102015211937
(43) Veröffentlichungstag der Anmeldung: 28.12.2016
(73) Patentinhaber: ROBERT BOSCH GMBH, 70442 Stuttgart (DE)
(72) Erfinder: Kreschel, Henning, 71640 Ludwigsburg (DE); Rapp, Holger, 71254 Ditzingen (DE)

(56) Entgegenhaltungen:
- DE-A1-102005 039 911
- DE-A1-102008 003 838
- US-A- 5 059 857

## Beschreibung

### Stand der Technik

Die Erfindung betrifft ein Piezoaktormodul nach dem Vorrichtungsanspruch 1. Ferner betrifft die Erfindung ein Verfahren zum Herstellen eines erfindungsgemäßen Piezoaktormoduls sowie einen Piezoinjektor mit einem erfindungsgemäßen Piezoaktormodul.

Ein Piezoaktormodul ist aus der DE 10 2008 003 838 A1 der Anmelderin bekannt. Auch aus DE 10 2005 039 911 A1 und US 5 059 857 sind ähnliche Piezoaktormodule bekannt. Das bekannte Piezoaktormodul dient als Bestandteil eines Piezoinjektors zum Einspritzen von Kraftstoff in einen Brennraum einer insbesondere selbstzündenden Brennkraftmaschine. Das bekannte Piezoaktormodul zeichnet sich dadurch aus, dass sich ein Piezoaktor, der eine Vielzahl von übereinander gestapelten Piezokeramikschichten aufweist, über Kontaktmittel elektrisch ansteuerbar ist, um dessen axiale Länge bzw. Erstreckung zu verändern. Dadurch lässt sich zumindest indirekt die Stellung eines in dem Piezoinjektor angeordneten Einspritzglieds (Düsennadel) verändern, um das Einspritzen von Kraftstoff in den Brennraum der Brennkraftmaschine zu steuern. Aufgrund der in dem Piezoinjektor herrschenden relativ hohen Drücke (gemeint sind dabei Systemdrücke von beispielsweise mehr als 2000 bar) ist der Piezoaktor in einem Piezoaktorgehäuse angeordnet, das aus einem Aktorfuß, einer Schutzhülse und einem Aktorkopf besteht, wobei die genannten Bauteile dicht miteinander verbunden sind, um den Eintritt von Kraftstoff in das Piezoaktorgehäuse zu vermeiden. Der Piezoaktor ist im Bereich der Schutzhülse mit radialem Spiel angeordnet und von einer elastischen Vergussmasse umgeben, die beim Betrieb der Wärmeübertragung dient. Die elektrische Kontaktierung des Piezoaktors erfolgt über Kontaktmittel in Form von Anschlußdrähten, die durch den Aktorfuß hindurchgeführt und dort abgedichtet angeordnet sind. Dabei kommen üblicherweise zwei, in Bezug auf eine Längsachse des Piezoaktors um 180° zueinander versetzt angeordnete Anschlussdrähte zur Anwendung, deren aus dem Aktorfuß heraustretende Abschnitte (die auch als Anschlusspins bezeichnet werden) an gegenüberliegend an der Umfangsfläche des Piezoaktors angeordneten Kontaktflächen über Schweißverbindungen mit dem Piezoaktor verbunden sind. Insbesondere während der Fertigung, aber auch aufgrund sonstiger Umstände, kann es zu minimalen Relativbewegungen zwischen dem Aktorfuß und dem Piezoaktor kommen, welche insbesondere den Abstand zwischen den Anschlussdrähten im Austrittsbereich aus dem Aktorfuß und der jeweiligen, die Schweißverbindung aufweisende Kontaktfläche am Piezoaktor verändern. Dadurch kann es entweder zu einer Vorschädigung oder aber zu einem Abreißen eines Anschlussdrahtes im Bereich zwischen dem Aktorfuß und der Schweißverbindung mit dem Piezoaktor kommen, da die in dem Anschlussdraht zwischen dem Aktorfuß und der Kontaktstelle auftretenden mechanischen Zugspannungen den Anschlussdraht überlasten können. Reißt der Anschlussdraht ab, so ist die elektrische Kontaktierung des Piezoaktors nicht mehr intakt, der Aktor kann nicht mehr angesteuert werden und der Piezoinjektor kann keinen Kraftstoff mehr in den Brennraum der Brennkraftmaschine einspritzen.

### Offenbarung der Erfindung

Ausgehend von dem dargestellten Stand der Technik liegt der Erfindung die Aufgabe zugrunde, ein Piezoaktormodul derart weiterzubilden, dass dieses mit Blick auf etwaige Relativbewegungen zwischen dem Aktorfuß und dem Piezoaktor besonders robust bzw. unempfindlich ausgebildet ist. Unter einer besonders robusten Ausbildung wird dabei eine zuverlässige elektrische Kontaktierung des Piezoaktors über die Kontaktmittel verstanden, welche auch beim Auftreten der angesprochenen Bewegungen derart ausgebildet ist, dass keine unzulässig hohen Spannungen bzw. Kräfte auf die Kontaktmittel einwirken.

Die erfindungsgemäß vorgesehenen Kompensationsmittel ermöglichen somit die bei Bewegungen zwischen dem Aktorfuß und dem Piezoaktor auftretenden (mechanischen) Spannungen zu reduzieren bzw. unzulässig hohe Kräfte zu vermeiden, wodurch die elektrische Verbindung zum Piezoaktor hin sichergestellt ist.

Vorteilhafte Weiterbildungen des erfindungsgemäßen Piezoaktormoduls sind in den Unteransprüchen angegeben.

In besonders bevorzugter konstruktiver Ausgestaltung der Kompensationsmittel ist es vorgesehen, dass diese ohne zusätzliche, separate Elemente ausgebildet sind, insbesondere dadurch, dass die Kontaktmittel in Form von Anschlussdrähten ausgebildet sind, dass die Anschlussdrähte im Aktorfuß, zumindest in einem Austrittsbereich aus dem Aktorfuß in Richtung zum Piezoaktor, starr angeordnet sind, dass die Kontaktflächen für die Anschlussdrähte in einem axialen Abstand zum Aktorfuß angeordnet sind, und dass die Anschlussdrähte eine gestreckte Länge aufweisen, die größer ist als der Abstand zwischen dem Austrittsbereich der Anschlussdrähte aus dem Aktorfuß und den Kontaktflächen am Piezoaktor. Mit anderen Worten gesagt bedeutet dies, dass die Kompensationsmittel durch eine spezielle Anordnung bzw. Ausbildung der sowieso vorhandenen Anschlussdrähte ausgebildet werden, so dass durch den Verzicht auf separate Elemente eine besonders einfache, kostengünstige und zuverlässige Ausbildung der Kompensationsmittel erzielt wird.

In Umsetzung der Idee eines eine größere gestreckte Länge aufweisenden Anschlussdrahtes ist es vorgesehen, dass der Anschlussdraht wenigstens einen gekrümmten oder schräg in Bezug zur Längsachse des Piezoaktors angeordneten Abschnitt aufweist, in dessen Bereich der Anschlussdraht nicht parallel zur Längsachse des Piezoaktors verläuft. Eine derartige Anordnung bewirkt bei einer Relativbewegung zwischen dem Piezoaktor und dem Aktorfuß eine Änderung der Position des gekrümmten oder schräg angeordneten Abschnitts zum Ausgleich eines vergrößerten Abstands zwischen dem Aktorfuß und der Kontaktfläche an dem Piezoaktor. Hierzu ist es auch erforderlich, dass der zwischen dem Aktorfuß und der Kontaktfläche an dem Piezoaktor angeordnete Bereich des Anschlussdrahts beweglich ist, d.h. beispielsweise nicht starr mit anderen Elementen verbunden ist.

Um auf besonders einfache Art und Weise eine größere Länge des Anschlussdrahts ohne scharfe Abschnitte o.ä. zu erzielen, ist es bevorzugt vorgesehen, dass der Anschlussdraht wenigstens einen bogenförmigen Abschnitt aufweist. Der bogenförmige Abschnitt hat insbesondere den Vorteil, dass die mechanischen Belastungen auf den Anschlussdraht während der Fertigung bzw. des Formens des Anschlussdrahts in dem relevanten Bereich besonders niedrig gehalten werden können, da keine scharfen Knicke im Anschlussdraht ausgebildet werden.

In Weiterbildung des zuletzt gemachten Vorschlags, die es ermöglicht, auf einem relativ kleinen Bereich eine besonders große gestreckte Länge des Anschlussdrahts zu ermöglichen, ist es vorgesehen, dass der Anschlussdraht mehrere, unterschiedliche Krümmungsrichtungen aufweisende Abschnitte aufweist, und dass der Anschlussdraht im Austrittsbereich aus dem Aktorfuß und an der Kontaktfläche am Piezoaktor vorzugsweise fluchtend zur Längsachse angeordnet ist. Eine derartige Ausbildung des Anschlussdrahts bewirkt bildlich gesprochen bei einer Vergrößerung des Abstands zwischen dem Aktorfuß und der Kontaktstelle am Piezoaktor eine Verlängerung (bzw. nachfolgend bei einer Verringerung des Abstands eine Stauchung) des Anschlussdrahts in Art einer Ziehharmonika.

Eine weitere bevorzugte Ausgestaltung des Piezoaktormoduls, die eine sichere Positionierung des Piezoaktors zum Aktorfuß ermöglicht, und insbesondere etwaige Querverschiebungen des Piezoaktors, beispielsweise beim Befüllen des radialen Zwischenraums zwischen dem Piezoaktor und der Schutzhülse vermeidet, wird vorgeschlagen, dass der Piezoaktor auf der dem Aktorfuß zugewandten Seite über einen Teilbereich der axialen Länge des Piezoaktors in einer Aufnahme des Aktorfußes formschlüssig mit radialem Montagespiel aufgenommen ist. Die Größe des radialen Montagespiels soll dabei insbesondere an Fertigungstoleranzen sowie an der Oberfläche des Piezoaktors angeordnete Bauteile angepasst sein, damit diese beim Einschieben in die Aufnahme des Aktorfußes nicht mechanisch beschädigt oder vorgeschädigt werden.

Um einerseits den Piezoaktor mit relativ hohen Strömen (gemeint sind hierbei Ströme von beispielsweise mehr als 10A) betreiben zu können, und anderseits auch eine mechanisch besonders robuste, herstellungstechnisch relativ einfach ausbildbare Verbindung zwischen dem Anschlussdraht und dem Piezoaktor zu ermöglichen, ist es darüber hinaus von Vorteil, wenn die Verbindung der Anschlussdrähte an den Kontaktflächen über ein an der Umfangsfläche des Piezoaktors über eine Metallisierungsschicht mit dem Piezoaktor verbundenes Drahtgitter in Form einer Schweißverbindung ausgebildet ist.

Die Erfindung umfasst auch ein Verfahren zum Herstellen eines soweit beschriebenen erfindungsgemäßen Piezoaktormoduls, wobei das Verfahren vorsieht, dass zunächst der Piezoaktor im Bereich einer Aufnahme des Aktorfußes positioniert wird. Anschließend werden die Anschlussdrähte mit dem Piezoaktor im Bereich von Kontaktflächen des Piezoaktors verbunden, insbesondere durch die angesprochenen Schweißverbindungen. Anschließend erfolgt ein Verbinden einer Schutzhülse mit dem Aktorfuß, wobei die Schutzhülse den Piezoaktor mit radialem Spiel umgibt. Danach erfolgt ein Ausfüllen des radialen Zwischenraums zwischen dem Piezoaktor und der Schutzhülse mit einer Vergussmasse. Die Vergussmasse soll dabei insbesondere auch Bewegungen der Anschlußdrähte ermöglichen. Zuletzt erfolgt ein Verbinden des Aktorkopfes mit der Schutzhülse zum Ausbilden eines dichten Piezoaktormoduls.

Zuletzt umfasst die Erfindung auch einen Piezoinjektor mit einem Haltekörper und einem in dem Haltekörper angeordneten, erfindungsgemäßen Piezoaktormodul. Ein derartiger Piezoinjektor ist insbesondere zum Einspritzen von Kraftstoff bei selbstzündenden Brennkraftmaschinen vorgesehen, wobei der Systemdruck beispielsweise mehr als 2000bar betragen kann.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: ein erfindungsgemäßes Piezoaktormodul in einem vereinfachten Längsschnitt,
- Fig. 2 bis Fig. 4: jeweils einen Aktorfuß und einen Piezoaktor bei unterschiedlich ausgebildeten Anschlussdrähten, jeweils in Seitenansicht und
- Fig. 5 bis Fig. 7: die Herstellung des in der Fig. 1 gezeigten Piezoaktormoduls während unterschiedlicher Phasen, jeweils im Längsschnitt.

Gleiche Elemente bzw. Elemente mit gleicher Funktion sind in den Figuren mit den gleichen Bezugsziffern versehen.

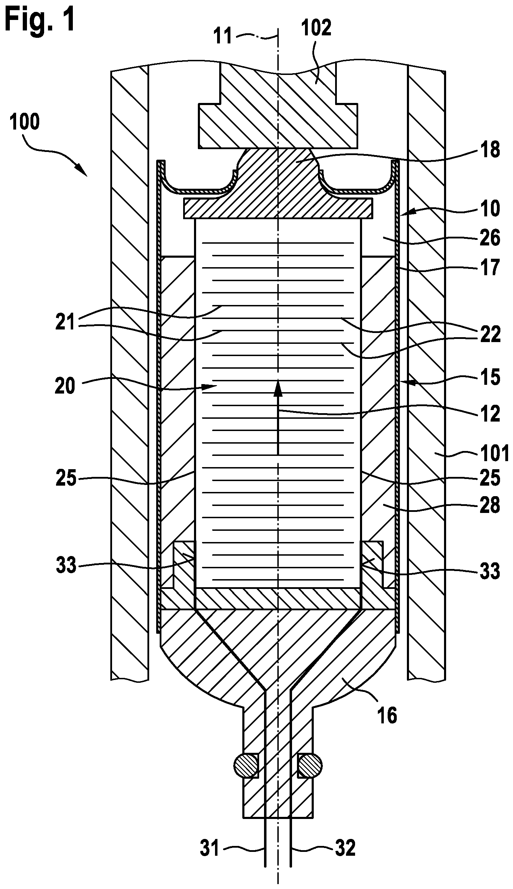

In der Fig. 1 ist ein Teilbereich eines Piezoinjektors 100 dargestellt, wie er insbesondere als Bestandteil eines sogenannten Common-Rail-Einspritzsystems zum Einspritzen von Kraftstoff in einen Brennraum in einer selbstzündenden Brennkraftmaschine dient. Der Piezoinjektor 100 weist einen Haltekörper 101 auf, in dessen Bereich ein Piezoaktormodul 10 angeordnet ist. Insbesondere kann es dabei vorgesehen sein, dass das Piezoaktormodul 10 innerhalb des Haltekörpers 101 mit radialem Spiel aufgenommen und von Kraftstoff umströmt ist. Ein Übertragungsglied 102, das mit dem Piezoaktormodul 10 in Wirkverbindung angeordnet ist, dient zur zumindest mittelbaren Bewegung eines in der Fig. 1 nicht dargestellten Einspritzglieds des Piezoinjektors 100, insbesondere in Form einer Düsennadel. Hierzu ist es vorgesehen, dass das Piezoaktormodul 10 aus der in der Fig. 1 gezeigten Ruhelage, in der das Piezoaktormodul 10 nicht bestromt ist, sich in Bezug auf eine Längsachse 11 des Piezoaktormoduls 10 in Richtung des Pfeils 12 (bei einer Bestromung) verlängert.

Das Piezoaktormodul 10 umfasst ein Piezoaktorgehäuse 15, das einen Aktorfuß 16, eine Schutzhülse 17 und einen Aktorkopf 18 aufweist. Die Schutzhülse 17 ist auf den gegenüberliegenden Seiten mit dem Aktorfuß 16 bzw. dem Aktorkopf 18 dichtend verbunden, um den Eintritt von Kraftstoff in den Innenraum des Piezoaktorgehäuses 15 zu vermeiden. Darüber hinaus ist der Aktorfuß 16 in Bezug zur Längsachse 11 in dem Haltekörper 101 fixiert aufgenommen, um eine Abstützung des Piezoaktormoduls 10 bei einer Verlängerung desselben und eine Kraftübertragung auf das Übertragungsglied 102 zu ermöglichen. Eine derartige Abstützung kann beispielsweise durch den Haltekörper 101 durch axiale Anlage des Piezoaktormoduls 10 erfolgen (nicht dargestellt).

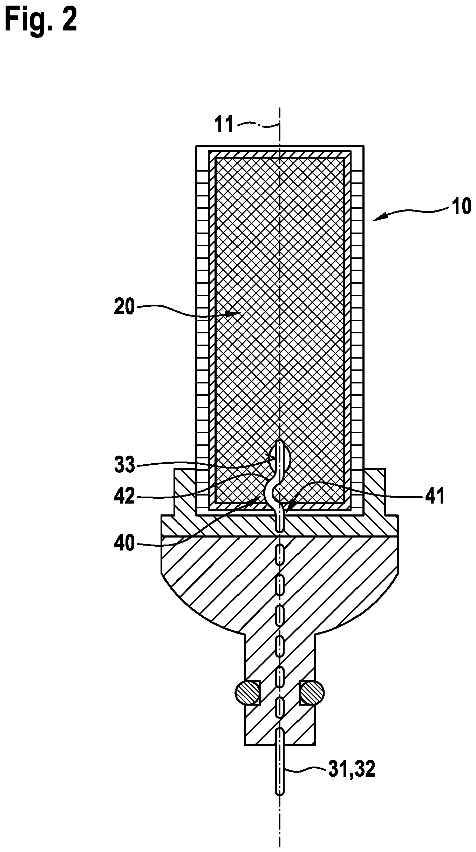

Das Piezoaktormodul 10 weist darüber hinaus einen aus einer Vielzahl von übereinander gestapelten Innenelektroden 21, 22 aufweisenden Piezoaktor 20 auf. Die Innenelektroden 21 bzw. 22 bilden zwei unterschiedliche Pole des Piezoaktors 20 aus und sind auf gegenüberliegenden Seiten jeweils untereinander elektrisch leitend verbunden. Hierzu dient eine in den Fig. 2 bis 4 erkennbare Metallisierungsschicht 24, die mit den Innenelektroden 21 bzw. 22 verbunden ist. Auf der Metallisierungsschicht 24 ist auf gegenüberliegenden Seiten jeweils ein Metallgitter 25 befestigt bzw. elektrisch leitend mit der Metallisierungsschicht 24 verbunden. Weiterhin ist der Piezoaktor 20, der sich in axialer Richtung der Längsachse 11 betrachtet zwischen dem Aktorfuß 16 und dem Aktorkopf 18 befindet, innerhalb der Schutzhülse 17 bzw. des Piezoaktorgehäuses 15 unter Ausbildung eines radialen Zwischenraums 26 in dem Piezoaktorgehäuse 15 angeordnet. Der radiale Zwischenraum 26 ist zumindest über einen Teilbereich der axialen Erstreckung des Piezoaktors 20, vorzugsweise zumindest nahezu bis in den Bereich des Aktorkopfes 18, von einer elastische Eigenschaften aufweisenden Vergussmasse 28 ausgefüllt.

Die elektrische Kontaktierung der jeweils untereinander über die Metallisierungsschicht 24 bzw. die Metallgitter 25 miteinander verbundenen Innenelektroden 21, 22 erfolgt mittels zweier Anschlußdrähte 31, 32, die als Kontaktmittel dienen. Die Anschlussdrähte 31, 32 sind innerhalb des Aktorfußes 16 auf nicht gezeigte, an sich bekannte Weise abgedichtet geführt und beispielsweise von dem Steuergerät der Kraftstoffeinspritzanlage mit Strom bzw. Spannung versorgbar. Die Anschlussdrähte 31, 32 sind im Bereich von Kontaktflächen 33 mit dem Metallgitter 25 bzw. dem Piezoaktor 20 verschweißt. Die Kontaktflächen 33 weisen in Bezug zur Längsachse 11 einen Abstand A zum Aktorfuß 16 auf. Der Abstand A beträgt beispielsweise, bezogen auf die axiale Länge L des Piezoaktors 20 etwa zwischen 10% und 20% der Länge L. Darüber hinaus weist der Aktorfuß 16 eine radial um die Längsachse 11 verlaufende Seitenwand 34 auf, die eine Aufnahme 35 für den Piezoaktor 20 ausbildet, der innerhalb der Aufnahme 35 mit lediglich geringem radialen Montagespiel angeordnet ist. Die Seitenwand 34 kann auch über größere Bereiche in Umfangsrichtung unterbrochen ausgebildet sein.

Erfindungsgemäß ist es vorgesehen, dass zum Ausgleich von Relativbewegungen zwischen dem Aktorfuß 16 und den Kontaktflächen 33 am Piezoaktor 20, welche beispielsweise durch ein Verkippen des Piezoaktors 20, durch ein Abheben des Piezoaktors 20 von dem Grund der Aufnahme 35 oder durch ein Verformen der fußseitigen Stirnfläche des Piezoaktors 20 im Betrieb erfolgen können, Kompensationsmittel 40 vorgesehen sind, die eine Veränderung des Abstands A, insbesondere eine Vergrößerung des Abstands A, kompensieren. Die Kompensationsmittel 40 werden durch eine spezielle Ausbildung bzw. Form der Anschlussdrähte 31, 32 gebildet, wozu zunächst auf die Darstellung der Fig. 2 verwiesen wird. Anhand der Fig. 2 ist erkennbar, dass der Anschlussdraht 31, 32 zwischen dem Austrittsbereich 41 aus dem Aktorfuß 16 und der Kontaktfläche 33, wo der Anschlussdraht 31, 32 jeweils fluchtend zur Längsachse 11 angeordnet ist, einen bogenförmigen Abschnitt 42 aufweist, der die gestreckte Länge des Anschlussdrahts 31, 32 verlängert, derart, dass die gestreckte Länge des Anschlussdrahts 31, 32 größer ist als der Abstand A zwischen dem Austrittsbereich 41 und der Kontaktfläche 33.

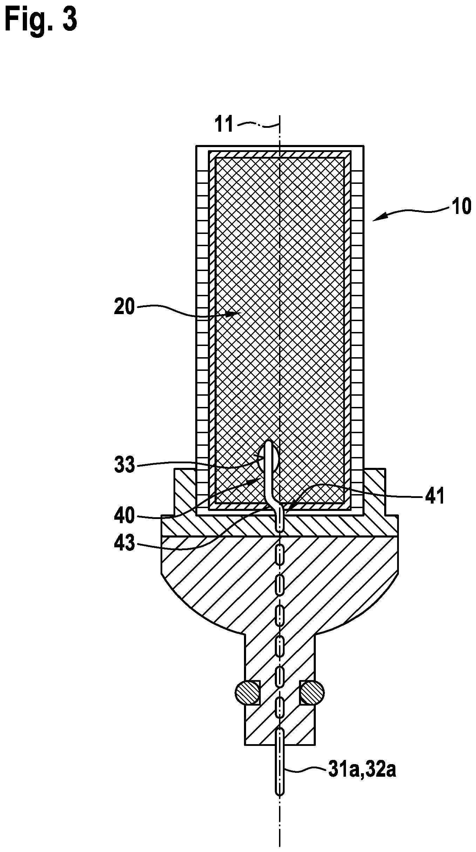

Bei dem in der Fig. 3 dargestellten Ausführungsbeispiel weist der Anschlussdraht 31a, 32a einen in Bezug zur Längsachse 11 schräg angeordneten Abschnitt 43 auf, wobei der Anschlussdraht 31a, 32a im Bereich des Austrittsbereichs 41 sowie der Kontaktfläche 33 jeweils geradlinig ausgebildet und fluchtend zur Längsachse 11 ausgerichtet ist.

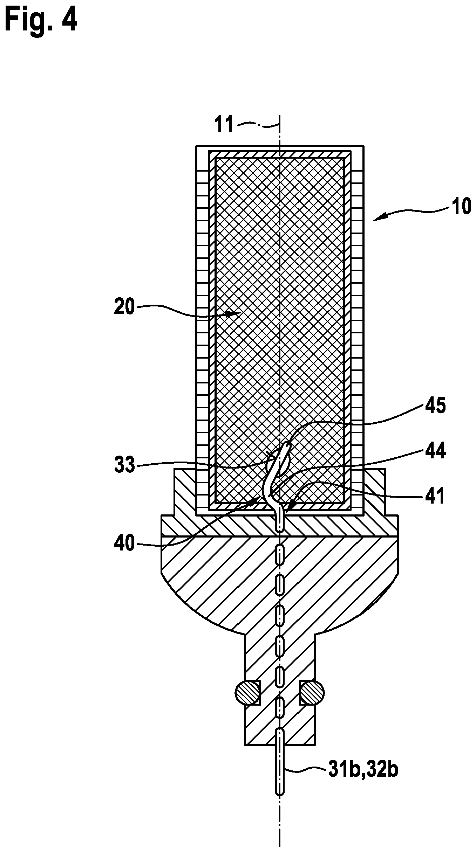

Bei dem in der Fig. 4 dargestellten Ausführungsbeispiel ist der Anschlussdraht 31b, 32b jeweils mit einem bogenförmigen Abschnitt 44 versehen, der auf der der Kontaktfläche 33 zugewandten Seite in einen gegenüber der Längsachse 11 schräg angeordneten Abschnitt 45 übergeht.

Bei den Fig. 2 bis 4 ist jeweils nur einer der beiden Anschlußdrähte 31, 31a, 31b, 32, 32a, 32b gezeigt. Der jeweils andere Anschlussdraht 31, 31a, 31b, 32, 32a, 32b ist um 180° zur Längsachse 11 zueinander versetzt angeordnet, derart, dass die Anschlußdrähte 31, 31a, 31b, 32, 32a, 32b im Bereich der Austrittsbereiche 41 sowie der Kontaktflächen 33 zueinander fluchtend ausgerichtet sind. Weiterhin sind sowohl die Kontaktflächen 33, als auch die Anschlußdrähte 31, 31a, 31b, 32, 32a, 32b in einem radialen Abstand zur Längsachse angeordnet.

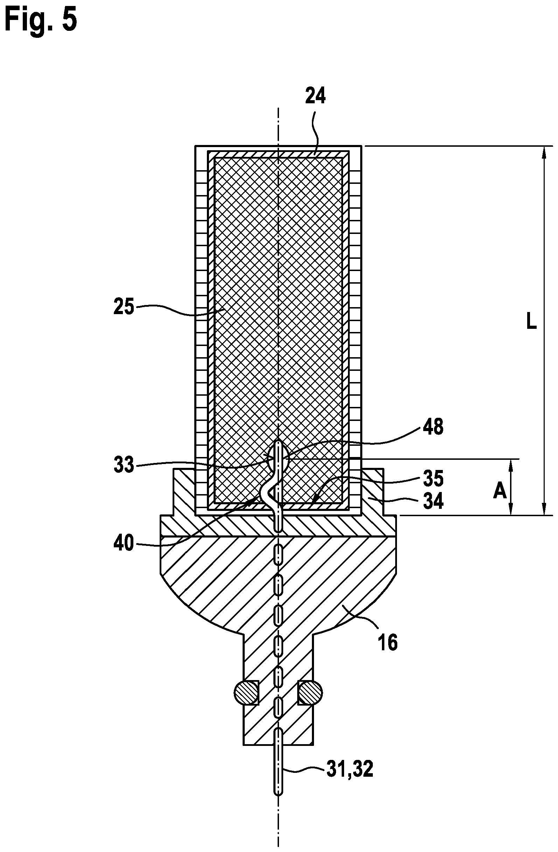

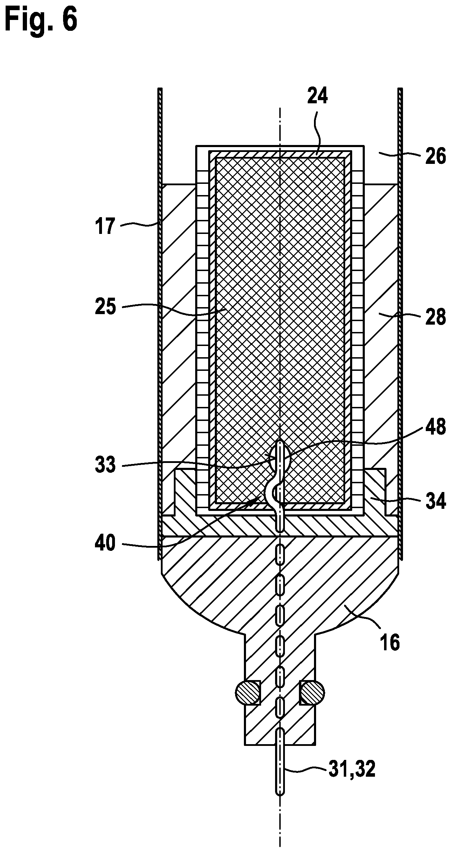

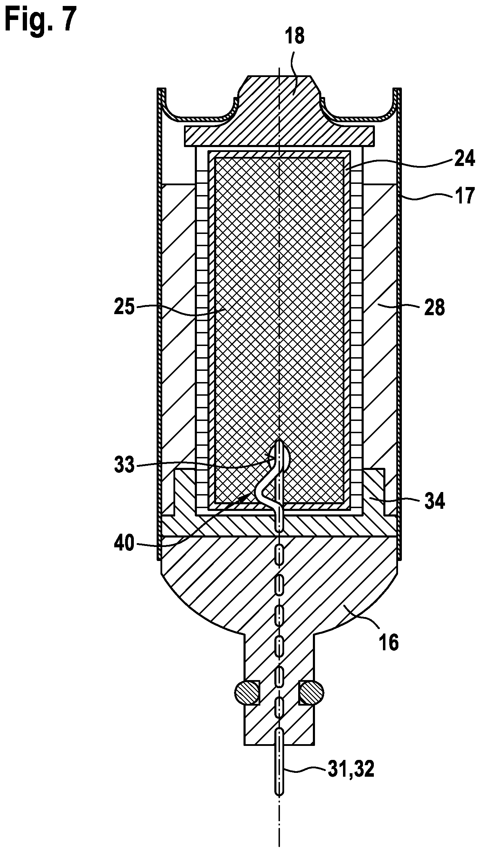

In den Fig. 5 bis 7 ist der Herstellungsprozess eines soweit beschriebenen Piezoaktormoduls 10 dargestellt. Hierbei wird entsprechend der Fig. 5 in einem ersten Schritt der Piezoaktor 20 in die Aufnahme 35 des Aktorfußes 16 eingebracht und darin positioniert, derart, dass der Piezoaktor 20 auf dem Aktorfuß 16 aufsitzt. Danach erfolgt das Kontaktieren des jeweiligen Anschlussdrahtes 31, 32 im Bereich der jeweiligen Kontaktfläche 33 mittels einer Schweißverbindung 48. In der Fig. 6 ist der Zustand dargestellt, bei dem der Aktorfuß 16 mit der Schutzhülse 17 verbunden ist, und der radiale Zwischenraum 26 von der Vergussmasse 28 ausgefüllt ist. Zuletzt erfolgt entsprechend der Darstellung der Fig. 7 die Verbindung zwischen dem Aktorkopf 18 und der Schutzhülse 17, wobei der Aktorkopf 18 auf der Oberseite des Piezoaktors 20 aufsitzt.

Das soweit beschriebene Piezoaktormodul 10 bzw. der Piezoaktor 20 können in vielfältiger Art und Weise abgewandelt bzw. modifiziert werden, ohne vom Erfindungsgedanken abzuweichen.

## Patentansprüche

1. Piezoaktormodul (10), mit einem Aktorfuß (16), einem Aktorkopf (18) und einem zwischen dem Aktorfuß (16) und dem Aktorkopf (18) angeordneten Piezoaktor (20) aus einer Vielzahl von Elektrodenschichten (21;22) verbunden über Metallgitter (25), wobei der Piezoaktor (20) in Bezug zu einer Längsachse (11) des Piezoaktormoduls (10) sich an den Aktorfuß (16) anschließt, und wobei Anschlussdrähte (31,32) vorgesehen sind, die durch den Aktorfuß (16) hindurchgeführt und mit dem Piezoaktor (20) an Kontaktflächen (33) der Metallgitter (25) starr verbunden sind, und mit einer Schutzhülse (17), die auf ihren gegenüberliegenden Seiten mit dem Aktorfuß (16) bzw. dem Aktorkopf (18) dichtend verbunden ist, und die Anschlussdrähte Kompensationsmittel (40) zum Ausgleich unterschiedlicher Abstände (A) zwischen dem Aktorfuß (16) und den Kontaktflächen (33) infolge von Relativbewegungen zwischen dem Aktorfuß (16) und dem Piezoaktor (20) aufweisen, wobei zwei, in Bezug zur Längsachse (11) um 180° zueinander versetzt angeordnete Anschlussdrähte (31; 31a; 31b, 32; 32a; 32b) vorgesehen sind, und wobei die Kontaktflächen (33) an dem Piezoaktor (20) in radialem Abstand zur Längsachse (11) angeordnet sind.

2. Piezoaktormodul nach Anspruch 1,
**dadurch gekennzeichnet,**
**dass** die Anschlussdrähte (31; 31a; 31b, 32; 32a; 32b) im Aktorfuß (16), zumindest in einem Austrittsbereich (41) aus dem Aktorfuß (16) in Richtung zum Piezomodul (20) starr angeordnet sind, dass die Kontaktflächen (33) für die Anschlussdrähte (31; 31a; 31b, 32; 32a; 32b) in einem axialen Abstand (A) zum Aktorfuß (16) angeordnet ist, und dass die Anschlussdrähte (31; 31a; 31b, 32; 32a; 32b) eine gestreckte Länge aufweisen, die größer ist als der Abstand (A) zwischen dem Austrittsbereich (41) der Anschlussdrähte (31; 31a; 31b, 32; 32a; 32b) aus dem Aktorfuß (16) und den Kontaktflächen (33) am Piezoaktor (20).

3. Piezoaktormodul nach Anspruch 2,
**dadurch gekennzeichnet,**
**dass** der Anschlussdraht (31; 31a; 31b, 32; 32a; 32b) in Bezug zur Längsachse (11) wenigstens einen gekrümmten oder schräg angeordneten Abschnitt (42 bis 45) aufweist, in dessen Bereich der Anschlussdraht (31; 31a; 31b, 32; 32a; 32b) nicht parallel zur Längsachse (11) verläuft.

4. Piezoaktormodul nach Anspruch 3,
**dadurch gekennzeichnet,**
**dass** der gekrümmte Abschnitt (42, 44) bogenförmig ausgebildet ist.

5. Piezoaktormodul nach Anspruch 3 oder 4,
**dadurch gekennzeichnet,**
**dass** der Anschlussdraht (31; 31a, 32; 32a) mehrere, unterschiedliche Krümmungsrichtungen aufweisende Abschnitte (42, 43) aufweist, und dass der Anschlussdraht (31; 31a, 32; 32a) im Austrittsbereich (41) aus dem Aktorfuß (16) und an der Kontaktfläche (33) am Piezoaktor (20) vorzugsweise fluchtend zur Längsachse (11) angeordnet ist.

6. Piezoaktormodul nach einem der Ansprüche 1 bis 5,
**dadurch gekennzeichnet,**
**dass** der Piezoaktor (20) auf der dem Aktorfuß (16) zugewandten Seite über einen Teilbereich der axialen Länge (L) des Piezoaktors (20) in einer Aufnahme (35) des Aktorfußes (16) formschlüssig mit radialem Montagespiel aufgenommen ist.

7. Piezoaktormodul nach einem der Ansprüche 1 bis 6,
**dadurch gekennzeichnet,**
**dass** die Verbindung der Anschlussdrähte (31; 31a; 31b, 32; 32a; 32b) an den Kontaktflächen (33) über ein an der Umfangsfläche des Piezoaktors (20) über eine Metallisierungsschicht (24) mit dem Piezoaktor (20) verbundenes Drahtgitter (25) in Form einer Schweißverbindung (48) ausgebildet ist.

8. Verfahren zum Herstellen eines Piezoaktormoduls (10) nach einem der Ansprüche 1 bis 7, umfassend zumindest folgende Schritte:
- Positionieren des Piezoaktors (20) im Bereich einer Aufnahme (35) des Aktorfußes (16)
- Verbinden von Anschlussdrähten (31; 31a; 31b, 32; 32a; 32b) mit dem Piezoaktor (20) im Bereich von Kontaktflächen (33) des Piezoaktors (20)
- Verbinden einer Schutzhülse (17) mit dem Aktorfuß (16), wobei die Schutzhülse (17) den Piezoaktor (20) mit radialem Spiel umgibt
- Ausfüllen des radialen Zwischenraums (26) zwischen dem Piezoaktor (20) und der Schutzhülse (17) mit einer Vergussmasse (28)
- Verbinden des Aktorkopfes (18) mit der Schutzhülse (17) .

9. Piezoinjektor (100), umfassend einen Haltekörper (101) und ein in dem Haltekörper (101) angeordnetes Piezoaktormodul (10), das nach einem der Ansprüche 1 bis 7 ausgebildet ist.

## Claims

1. Piezo actuator module (10), comprising an actuator base (16), an actuator head (18) and a piezo actuator (20) which is arranged between the actuator base (16) and the actuator head (18) and is composed of a large number of electrode layers (21; 22) connected by means of metal lattices (25), wherein the piezo actuator (20) adjoins the actuator base (16) with respect to a longitudinal axis (11) of the piezo actuator module (10), and wherein connection wires (31, 32) are provided, which connection wires are routed through the actuator base (16) and are rigidly connected to the piezo actuator (20) at contact faces (33) of the metal lattices (25), and comprising a protective sleeve (17) which, on its opposite sides, is connected in a sealing manner to the actuator base (16) and, respectively, to the actuator head (18), and the connection wires have compensation means (40) for equalizing different distances (A) between the actuator base (16) and the contact faces (33) as a result of relative movements between the actuator base (16) and the piezo actuator (20), wherein two connection wires (31; 31a; 31b, 32; 32a; 32b) which are arranged offset through 180° in relation to one another with respect to the longitudinal axis (11) are provided, and wherein the contact faces (33) are arranged on the piezo actuator (20) at a radial distance from the longitudinal axis (11) .

2. Piezo actuator module according to Claim 1, **characterized in that** the connection wires (31; 31a; 31b, 32; 32a; 32b) in the actuator base (16), at least in an outlet region (41) out of the actuator base (16) in the direction towards the piezo module (20), are rigidly arranged, **in that** the contact faces (33) for the connection wires (31; 31a; 31b, 32; 32a; 32b) are arranged at an axial distance (A) from the actuator base (16), and **in that** the connection wires (31; 31a; 31b, 32; 32a; 32b) have an extended length which is greater than the distance (A) between the outlet region (41) of the connection wires (31; 31a; 31b, 32; 32a; 32b) out of the actuator base (16) and the contact faces (33) on the piezo actuator (20).

3. Piezo actuator module according to Claim 2, **characterized in that** the connection wire (31; 31a; 31b, 32; 32a; 32b) has at least one curved or obliquely arranged section (42 to 45) with respect to the longitudinal axis (11), the connection wire (31; 31a; 31b, 32; 32a; 32b) not running parallel in relation to the longitudinal axis (11) in the region of the said curved or obliquely arranged section.

4. Piezo actuator module according to Claim 3, **characterized in that** the curved section (42, 44) is of arcuate design.

5. Piezo actuator module according to Claim 3 or 4, **characterized in that** the connection wire (31; 31a, 32; 32a) has a plurality of sections (42, 43) which have different directions of curvature, and **in that** the connection wire (31; 31a, 32; 32a) is arranged in the outlet region (41) out of the actuator base (16) and on the contact face (33) on the piezo actuator (20) preferably in alignment in relation to the longitudinal axis (11).

6. Piezo actuator module according to one of Claims 1 to 5, **characterized in that** the piezo actuator (20), on that side which faces the actuator base (16), is accommodated in an interlocking manner with radial mounting play in a receptacle (35) of the actuator base (16) over a subregion of the axial length (L) of the piezo actuator (20).

7. Piezo actuator module according to one of Claims 1 to 6, **characterized in that** the connection of the connection wires (31; 31a; 31b, 32; 32a; 32b) at the contact faces (33) by means of a wire lattice (25) which is connected to the piezo actuator (20) by means of a metallization layer (24) at the circumferential face of the piezo actuator (20) is designed in the form of a weld connection (48).

8. Method for producing a piezo actuator module (10) according to one of Claims 1 to 7, comprising at least the following steps:
- positioning the piezo actuator (20) in the region of a receptacle (35) of the actuator base (16)
- connecting connection wires (31; 31a; 31b, 32; 32a; 32b) to the piezo actuator (20) in the region of contact faces (33) of the piezo actuator (20)
- connecting a protective sleeve (17) to the actuator base (16), wherein the protective sleeve (17) surrounds the piezo actuator (20) with radial play
- filling the radial intermediate space (26) between the piezo actuator (20) and the protective sleeve (17) with a potting compound (28)
- connecting the actuator head (18) to the protective sleeve (17).

9. Piezo injector (100) comprising a retaining body (101) and a piezo actuator module (10) which is arranged in the retaining body (101) and is designed according to one of Claims 1 to 7.

## Revendications

1. Module actionneur piézoélectrique (10), comprenant un pied d'actionneur (16), une tête d'actionneur (18) et un actionneur piézoélectrique (20) disposé entre le pied d'actionneur (16) et la tête d'actionneur (18) et constitué d'une pluralité de couches d'électrode (21 ; 22) reliées par une grille métallique (25), l'actionneur piézoélectrique (20) se raccordant au pied d'actionneur (16) en référence à un axe longitudinal (11) du module actionneur piézoélectrique (10) et des fils de raccordement (31, 32) étant présents, lesquels passent à travers le pied d'actionneur (16) et sont reliés de manière rigide à l'actionneur piézoélectrique (20) au niveau de surfaces de contact (33) de la grille métallique (25), et comprenant une douille de protection (17) qui, sur ses côtés opposés, est reliée de manière étanche au pied d'actionneur (16) ou à la tête d'actionneur (18), et les fils de raccordement possédant des moyens de compensation (40) destinés à compenser les écarts (A) différents entre le pied d'actionneur (16) et les surfaces de contact (33) résultant de mouvements relatifs entre le pied d'actionneur (16) et l'actionneur piézoélectrique (20), deux fils de raccordement (31 ; 31a ; 31b, 32 ; 32a ; 32b) disposés décalés de 180° les uns par rapport aux autres par rapport à l'axe longitudinal (11) étant présents, et les surfaces de contact (33) étant disposées au niveau de l'actionneur piézoélectrique (20) à distance radiale de l'axe longitudinal (11).

2. Module actionneur piézoélectrique selon la revendication 1, **caractérisé en ce que** les fils de raccordement (31 ; 31a ; 31b, 32 ; 32a ; 32b) sont disposés de manière rigide dans le pied d'actionneur (16), au moins dans une zone de sortie (41) hors du pied d'actionneur (16) en direction du module piézoélectrique (20), **en ce que** les surfaces de contact (33) pour les fils de raccordement (31 ; 31a ; 31b, 32 ; 32a ; 32b) sont disposées à un écart (A) axial du pied d'actionneur (16), et **en ce que** les fils de raccordement (31 ; 31a ; 31b, 32 ; 32a ; 32b) possèdent une longueur étirée qui est supérieure à l'écart (A) entre la zone de sortie (41) des fils de raccordement (31 ; 31a ; 31b, 32 ; 32a ; 32b) hors du pied d'actionneur (16) et les surfaces de contact (33) au niveau de l'actionneur piézoélectrique (20).

3. Module actionneur piézoélectrique selon la revendication 2, **caractérisé en ce que** le fil de raccordement (31 ; 31a ; 31b, 32 ; 32a ; 32b) possède au moins une portion (42 à 45) curviligne ou disposée en biais par rapport à l'axe longitudinal (11), dans la zone de laquelle le fil de raccordement (31 ; 31a ; 31b, 32 ; 32a ; 32b) ne s'étend pas parallèlement à l'axe longitudinal (11).

4. Module actionneur piézoélectrique selon la revendication 3, **caractérisé en ce que** la portion (42, 44) curviligne est réalisée en forme d'arc.

5. Module actionneur piézoélectrique selon la revendication 3 ou 4, **caractérisé en ce que** le fil de raccordement (31 ; 31a, 32 ; 32a) possède plusieurs portions (42, 43) qui présentent des directions de courbure différentes et que le fil de raccordement (31 ; 31a, 32 ; 32a) est disposé dans la zone de sortie (41) hors du pied d'actionneur (16) et au niveau de la surface de contact (33) sur l'actionneur piézoélectrique (20), de préférence dans l'alignement de l'axe longitudinal (11) .

6. Module actionneur piézoélectrique selon l'une des revendications 1 à 5, **caractérisé en ce que** l'actionneur piézoélectrique (20) est accueilli avec un jeu de montage radial sur le côté qui fait face au pied d'actionneur (16) par le biais d'une zone partielle de la longueur axiale (L) de l'actionneur piézoélectrique (20) par complémentarité de formes dans un logement (35) du pied d'actionneur (16).

7. Module actionneur piézoélectrique selon l'une des revendications 1 à 6, **caractérisé en ce que** la liaison des fils de raccordement (31 ; 31a ; 31b, 32 ; 32a ; 32b) au niveau des surfaces de contact (33) est réalisée par le biais d'une grille de connexion (25) sous la forme d'une liaison soudée (48) reliée à l'actionneur piézoélectrique (20) au niveau de la surface périphérique de l'actionneur piézoélectrique (20) par le biais d'une couche de métallisation (24).

8. Procédé de fabrication d'un module actionneur piézoélectrique (10) selon l'une des revendications 1 à 7, comprenant au moins les étapes suivantes :
- positionnement de l'actionneur piézoélectrique (20) dans la zone d'un logement (35) du pied d'actionneur (16),
- connexion de fils de raccordement (31 ; 31a ; 31b, 32 ; 32a ; 32b) à l'actionneur piézoélectrique (20) dans la zone de surfaces de contact (33) de l'actionneur piézoélectrique (20),
- connexion d'une douille de protection (17) au pied d'actionneur (16), la douille de protection (17) entourant l'actionneur piézoélectrique (20) avec un jeu radial,
- remplissage de l'espace intermédiaire radial (26) entre l'actionneur piézoélectrique (20) et la douille de protection (17) avec une masse de scellement (28),
- connexion de la tête d'actionneur (18) à la douille de protection (17).

9. Injecteur piézoélectrique (100), comprenant un corps de maintien (101) et un module actionneur piézoélectrique (10) disposé dans le corps de maintien (101), lequel est réalisé selon l'une des revendications 1 à 7.
